# FASCICULE DE BREVET EUROPEEN

(11) **EP 2 955 350 B1**
(45) Date de publication et mention de la délivrance du brevet: **08.08.2018**
(21) Numéro de dépôt: 15170620.7
(22) Date de dépôt: 03.06.2015
(51) Int. Cl.: F01N 5/02, H01L 35/30

(54) **DISPOSITIF DE CONTRÔLE DE DÉBIT DESTINÉ À ÊTRE UTILISÉ DANS UN GÉNÉRATEUR THERMOÉLECTRIQUE COMPRENANT UN TEL DISPOSITIF**
DURCHSATZKONTROLLVORRICHTUNG, DIE DAZU BESTIMMT IST, IN EINEM THERMOELEKTRISCHEN GENERATOR VERWENDET ZU WERDEN, DER MIT EINER SOLCHEN VORRICHTUNG AUSGESTATTET IST
FLOW CONTROL DEVICE INTENDED FOR BEING USED IN A THERMOELECTRIC GENERATOR INCLUDING SUCH A DEVICE

(30) Priorité: 10.06.2014 FR 1455215
(43) Date de publication de la demande: 16.12.2015
(73) Titulaire: VALEO SYSTEMES THERMIQUES, 78321 Le Mesnil Saint Denis (FR); Simonin, Michel, 78960 Voisins le Bretonneux (FR)
(72) Inventeur: Simonin, Michel, 78960 Voisins-Le-Bretonneux (FR)
(74) Mandataire: Gevers & Orès

(56) Documents cités:
- EP-A1- 2 381 083
- WO-A2-2011/011795
- DE-A1-102011 016 808
- JP-A- 2008 274 790

## Description

L'invention concerne un générateur thermoélectrique comprenant un dispositif de contrôle de débit.

Dans le domaine automobile, il a déjà été proposé des dispositifs thermoélectriques utilisant des éléments, dits thermoélectriques, permettant de générer un courant électrique en présence d'un gradient de température entre deux de leurs faces opposées selon le phénomène connu sous le nom d'effet Seebeck. Ces dispositifs sont aussi appelés générateurs thermoélectriques.

Il est connu de positionner ces générateurs thermoélectriques dans une ligne d'échappement de véhicule automobile, voire dans le circuit de gaz d'échappement recirculés pour les véhicules automobiles présentant un tel circuit entre l'échappement et l'admission du moteur thermique. L'objectif est l'utilisation de la chaleur des gaz d'échappement des véhicules automobile pour générer de l'énergie électrique.

Il existe un besoin de contrôle du débit des gaz d'échappement pour favoriser un bon fonctionnement du moteur et optimiser les performances desdits générateurs thermoélectriques.

Il est connu du document DE102011016808 de placer une vanne de contrôle de débit en entrée d'un générateur thermoélectrique, pour contrôler le débit de fluide passant dans le canal intérieur du générateur. Cependant, ce type d'installation montre ses limites, et l'objectif de la présente invention consiste à proposer un générateur offrant des performances bien supérieures.

Ainsi, l'invention concerne un générateur thermoélectrique comprenant un dispositif de contrôle de débit, ledit générateur permettant la création d'un gradient de température entre une source froide et une source chaude en au moins deux zones.

Selon l'invention, ledit dispositif de contrôle de débit comprend une vanne, ladite vanne comprenant un corps de vanne et un clapet, ledit clapet étant articulé par rapport au corps de vanne et étant apte à occuper une position ouverte et une position fermée, ladite vanne étant positionnée à l'intérieur dudit générateur, entre lesdites deux zones, de manière à moduler la quantité d'un premier fluide circulant à travers ledit générateur thermoélectrique, ledit générateur thermoélectrique comprenant un faisceau de modules thermoélectriques, ladite vanne étant configurée pour dévier radialement ledit premier fluide à travers le faisceau.

Grâce à un tel dispositif de contrôle, l'invention permet de moduler le débit des gaz d'échappement à travers le générateur et les pertes de charge associées.

Le dispositif de contrôle selon l'invention permet, en outre, de simplifier son implantation. En effet, intégré au sein du générateur thermoélectrique, il n'est plus nécessaire de prévoir son implantation en amont ou en aval dudit générateur.

Selon différents modes de réalisation de l'invention, qui pourront être pris ensemble ou séparément :
- le dispositif de l'invention est configuré pour que le premier fluide soit la source chaude dudit générateur,
- ledit corps de vanne comprend des premiers évidements sur sa périphérie,
- ledit corps est configuré pour que ledit premier fluide circule à travers lesdits premiers évidements lorsque le clapet occupe la position fermée,
- ledit premier fluide est un gaz chaud,
- ledit corps de vanne comprend des seconds évidements sur sa périphérie, les seconds évidements étant distincts desdits premiers évidements,
- ledit corps est configuré pour qu'un second fluide constituant la source froide circule à travers lesdits seconds évidements, que la vanne occupe sa position ouverte ou sa position fermée,
- ledit second fluide est un liquide de refroidissement,
- ledit corps de vanne comprend un orifice central, ouvert ou non en fonction de la position du clapet,
- ledit clapet comprend un volet et un axe d'entrainement dudit volet,
- ledit corps comprend un support d'articulation dudit axe d'entrainement.

Ledit générateur comprend deux zones permettant chacune la création d'un gradient de température entre une source froide et une source chaude et ledit dispositif est situé entre lesdites deux zones.

Selon différents modes de réalisation de l'invention, qui pourront être pris ensemble ou séparément :
- le générateur thermoélectrique de l'invention comprend un faisceau de modules thermoélectriques, ledit faisceau étant tubulaire de manière à définir intérieurement un conduit d'écoulement dudit premier fluide à travers ledit corps de vanne en position ouverte dudit clapet de manière à permettre une circulation dudit fluide à travers ledit générateur en évitant de passer à travers ledit faisceau,
- lesdits modules comprennent au moins un élément thermoélectrique de forme annulaire, susceptible de générer un courant électrique sous l'action dudit gradient de température, prévu entre deux de ses faces, l'une, dite première face, étant définie par une surface de périphérie extérieure et l'autre, dite seconde face, étant définie par une surface de périphérie intérieure,
- ledit faisceau présente une section sensiblement circulaire, ladite vanne étant configurée pour dévier radialement ledit premier fluide à travers le faisceau, de l'intérieur vers l'extérieur dudit conduit,
- le générateur thermoélectrique de l'invention comprend un boitier configuré pour guider, notamment axialement, ledit premier fluide à travers ledit corps de vanne entre ledit faisceau et une paroi dudit boitier,
- ledit boitier est configuré pour guider radialement ledit premier fluide en aval de la vanne de l'extérieur vers l'intérieur dudit conduit,
- ledit générateur comprend des tubes de circulation du second fluide passant par lesdits seconds évidements du corps du dispositif de contrôle,
- lesdits tubes de circulation du second fluide passent à travers lesdits éléments thermoélectriques et sont configurés pour être en relation d'échange thermique avec leur surface de périphérie intérieure,
- le générateur thermoélectrique de l'invention comprend des premières surfaces d'échange secondaire avec le premier fluide, lesdites premières surfaces d'échange secondaire étant des ailettes qui relient les modules entre eux,
- les ailettes comprennent un revêtement catalytique pour assurer une conversion catalytique de composants toxiques du premier fluide,
- le générateur thermoélectrique de l'invention est configuré pour être positionné dans une ligne d'échappement de véhicule automobile de sorte que les gaz d'échappement circulant dans ladite ligne définissent ledit premier fluide et/ou dans un circuit de gaz d'échappement recirculés de véhicule automobile de sorte que lesdits gaz d'échappement recirculés circulant dans ledit circuit définissent ledit premier fluide.

L'invention sera mieux comprise, et d'autres buts, détails, caractéristiques et avantages de celle-ci apparaîtront plus clairement au cours de la description explicative détaillée qui va suivre, d'au moins un mode de réalisation de l'invention donné à titre d'exemple purement illustratif et non limitatif, en référence aux dessins schématiques annexés.

Sur ces dessins :
- la figure 1 est une représentation schématique en élévation d'une vanne selon l'invention,
- la figure 2 est une représentation schématique en coupe longitudinale d'un générateur thermoélectrique selon l'invention lorsqu'il est monté en série entre un moteur thermique (non représenté) et un système catalytique, le moteur thermique étant en phase de démarrage et la vanne de l'invention ouverte,
- la figure 3 est une représentation similaire de celle de la figure 2, la vanne étant fermée,
- la figure 4 est une représentation similaire de celle de la figure 2, la vanne occupant une position intermédiaire entre sa position ouverte et sa position fermée,
- la figure 5 est la même configuration qu'à la figure 2, le moteur thermique étant dans une phase de fonctionnement postérieure à la phase de démarrage,
- la figure 6 est une représentation schématique en élévation d'un faisceau de modules thermoélectriques d'un générateur thermoélectrique selon l'invention.

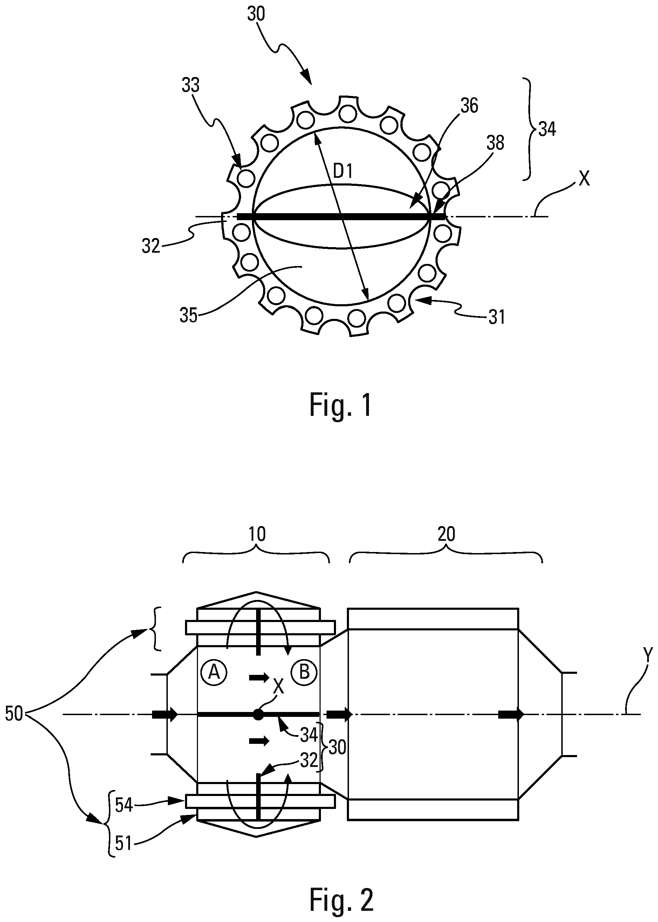

Comme illustré à la figure 1, l'invention concerne un générateur thermoélectrique comprenant un dispositif de contrôle de débit. Les figures 2 à 5 illustrent schématiquement un générateur thermoélectrique 10 selon l'invention, en particulier lorsqu'il est monté en série entre un moteur thermique (non représenté) et un système catalytique 20.

A titre d'exemple, le générateur thermoélectrique de l'invention 10 est configuré pour être positionné dans une ligne d'échappement de véhicule automobile et/ou dans un circuit de gaz d'échappement recirculés de véhicule automobile.

Le système catalytique 20 illustré ici à titre d'exemple, contrôle l'émission des gaz d'échappement en sortie du véhicule automobile ; son fonctionnement ne faisant pas l'objet de l'invention, il ne sera pas détaillé.

Le générateur thermoélectrique 10 comprend des modules thermoélectriques qui sont aptes à créer de l'électricité lorsqu'une de leur face est en contact avec une source froide et lorsqu'une seconde de leur face est en contact avec une source chaude. Les gaz d'échappement dudit véhicule automobile sont utilisés, ici, comme source chaude par le générateur 10 afin de générer un gradient de température avec la source froide.

Le dispositif de contrôle de débit de l'invention a pour fonction de moduler le débit desdits gaz d'échappement, ou source chaude, à travers ledit générateur 10.

Ainsi, le dispositif de contrôle de débit de l'invention comprend une vanne 30 (illustrée en détails à la figure 1).

Ladite vanne 30 comprend un corps de vanne 32 et un clapet 34. Le corps de vanne 32 comprend un orifice central 35 ouvert ou non en fonction de la position du clapet 34. En effet, ledit clapet 34 comprend un volet 36 et un axe d'entrainement X dudit volet. Autrement dit, le clapet 34 est articulé par rapport au corps de vanne 32. L'axe d'entrainement, repéré X sur les figures 1 à 5, est articulé via un support d'articulation 38 sur le corps 32.

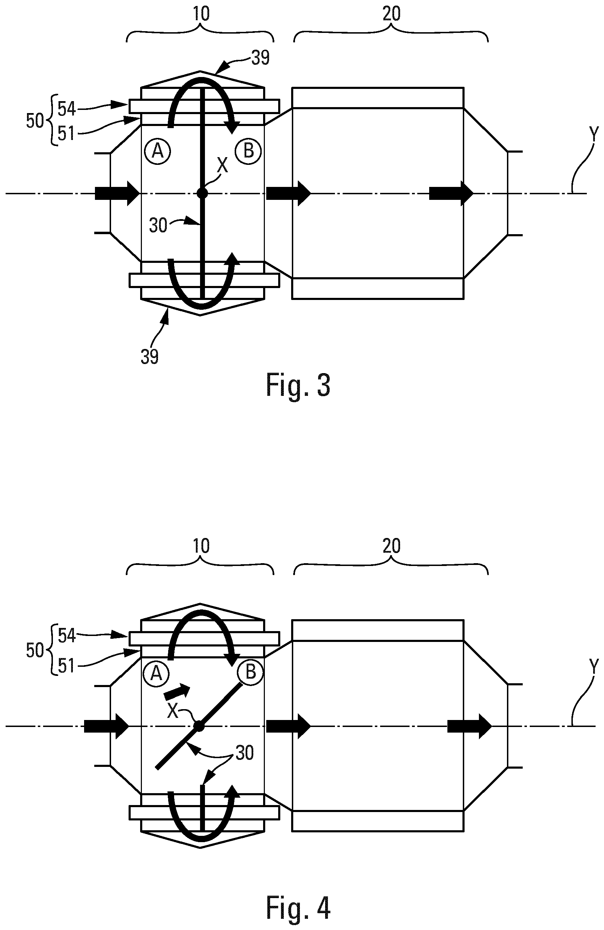

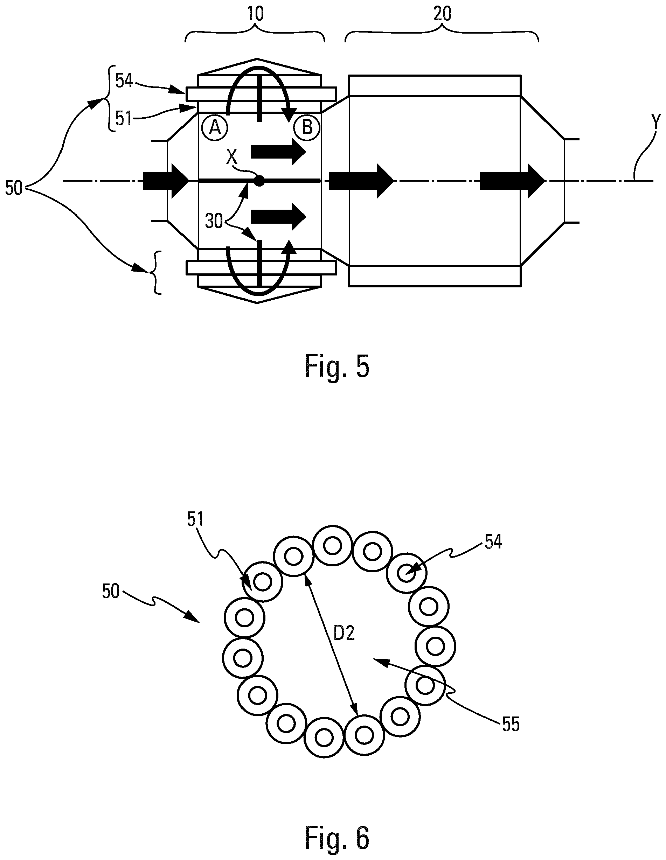

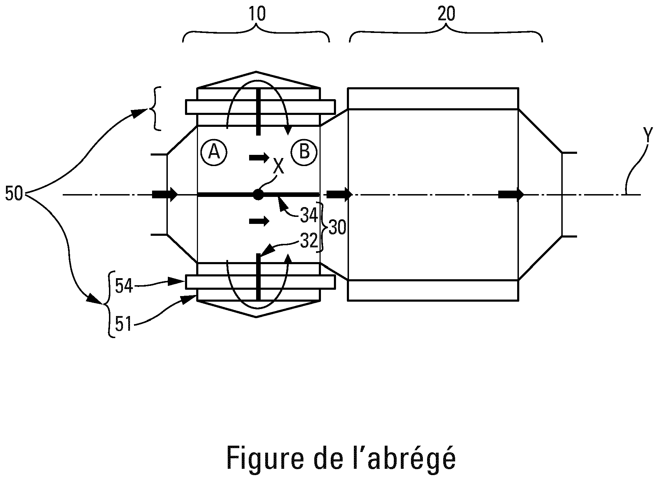

Ainsi, la vanne 30 est apte à occuper une position ouverte (voir figures 2 et 5), une position fermée (voir figure 3), ou une position intermédiaire (voir figure 4). Le dispositif pourra comprendre pour cela des moyens d'actionnement du volet, non représentés, par exemple intégrés au générateur. Ils sont avantageusement configurés pour permettre audit volet d'occuper toute position angulaire.

Selon l'invention, ladite vanne est configurée pour être à l'intérieur dudit générateur 10, entre deux zones A, B, ce qui permet un haut degré d'intégration du dispositif de contrôle dans le générateur 10.

Le parcours desdits gaz est schématisé par des flèches droites et/ou courbes sur les figures 2 à 5. Les flèches droites représentent un débit de gaz selon l'axe du générateur 10 et du système catalytique 20, dit axe principal et repéré Y sur les figures. Les flèches courbes représentent un débit qualifié de radial, autour d'un axe colinéaire à l'axe Y, en particulier au niveau du faisceau 50 décrit dans la suite. Schématiquement, nous avons représenté un débit important par des flèches plus épaisses.

Comme évoqué ci-dessus, le générateur thermoélectrique 10 comprend un faisceau 50 de modules thermoélectriques.

Lesdits modules comprennent au moins un élément thermoélectrique 51, ici de forme annulaire. Assemblés coaxialement entre eux, ces éléments thermoélectriques 51 forment des crayons thermoélectriques 51. Lesdits éléments thermoélectriques 51 et, par la suite, lesdits crayons thermoélectriques 51 sont susceptibles de générer un courant électrique sous l'action d'un gradient de température. C'est pourquoi les crayons thermoélectriques 51 comportent en leur centre des tubes 54 dans lesquels circule un fluide liquide de refroidissement qui agit comme source froide.

Les modules thermoélectriques pourront en outre comprendre des ailettes, non représentées, de préférence métalliques. Les ailettes servent de surfaces d'échange secondaires avec les gaz chauds. Lesdites ailettes sont avantageusement configurées pour lier les modules thermoélectriques entre eux. Elles peuvent, en outre, comprendre un revêtement catalytique pour assurer une conversion catalytique de composants toxiques des gaz chauds.

Les modules thermoélectriques comprennent donc au moins un élément thermoélectrique 51, ici une pluralité d'éléments thermoélectrique 51 de forme annulaire, susceptibles de générer un courant électrique sous l'action d'un gradient de température exercé entre deux de ses faces, l'une, dite première face, étant définie par une surface de périphérie extérieure, cylindrique, et l'autre, dite seconde face, étant définie par une surface de périphérie intérieure, cylindrique.

Lesdites première et seconde faces sont, par exemple, de section ovales pour les premières et/ou circulaires pour les secondes. De façon plus générale, toute section de forme arrondie et/ou polygonale est possible.

De tels éléments 51 fonctionnent, selon l'effet Seebeck, en permettant de créer un courant électrique dans une charge connectée entre lesdites faces soumises au gradient de température. De façon connue de l'homme du métier, de tels éléments 51 sont constitués, par exemple, de Bismuth et de Tellurium (Bi2Te3).

Les éléments thermoélectriques 51 pourront être, pour une première partie, des éléments d'un premier type, dit P, permettant d'établir une différence de potentiel électrique dans un sens, dit positif, lorsqu'ils sont soumis à un gradient de température donné, et, pour l'autre partie, des éléments d'un second type, dit N, permettant la création d'une différence de potentiel électrique dans un sens opposé, dit négatif, lorsqu'ils sont soumis au même gradient de température.

Les éléments thermoélectriques 51 sont constitués d'un anneau en une seule pièce. Ils pourront cependant être formés de plusieurs pièces formant chacune une portion angulaire de l'anneau.

La première surface présente, par exemple, un rayon compris entre 1,5 et 4 fois le rayon de la seconde surface. Il pourra s'agir d'un rayon égal à environ deux fois celui de seconde surface.

Ledit élément thermoélectrique 51 présente, par exemple, deux faces planes parallèles opposées. Autrement dit, l'anneau constituant l'élément thermoélectrique 51 est de section annulaire rectangulaire.

Comme illustré à la figure 6, le faisceau 50 est tubulaire. Il définit ainsi un conduit d'écoulement 55 pour lesdits gaz. Ce conduit d'écoulement 55 est formé entre autres, par lesdites zones A, B. Ainsi, lorsque la vanne 30 est ouverte, les gaz circulent à travers la partie du conduit correspondant à ladite zone A, ladite vanne 30 et la partie dudit conduit correspondant à ladite zone B, seule une faible fraction desdits gaz passant à travers le faisceau 50.

Le corps de vanne 32 et le conduit d'écoulement 55 sont avantageusement coaxiaux. Le diamètre de l'orifice central 35 du corps de vanne 32, noté D1 sur la figure 1, est inférieur à la distance D2 séparant deux crayons thermoélectriques 51 diamétralement opposés du faisceau 50 (voir figure 6).

La figure 2 illustre une configuration dans laquelle la vanne 30 est ouverte et seule une faible portion des gaz passent à travers le faisceau 50. Ce cas de figure apparait en particulier lors du démarrage du moteur thermique (moteur non illustré). La température des gaz est alors, par exemple, inférieure à 400°C pour un fluide de refroidissement dont la température est, par exemple, inférieure à 100°C. Il est à noter que la fraction des gaz traversant le faisceau favorise le transfert de la chaleur des gaz chauds dans le liquide froid lors des phases de démarrage moteur, ce qui pourra permettre d'accélérer sa mise en température nominale.

La figure 5 illustre une configuration voisine de celle de la figure 2. Le moteur n'étant pas en phase de démarrage, il est alors possible de quantifier le débit des gaz : ce débit est supérieur, par exemple, à 70g/s. La température des gaz est alors supérieure, par exemple, à 750°C. On peut constater sur cette figure que les gaz chauds évitent encore de passer par le faisceau 50.

D'autre part, lorsque la vanne 30 est en position fermée (voir figure 3), les gaz sont guidés vers le faisceau 50 qu'ils traversent radialement. Lesdits gaz sont alors guidés, notamment axialement, à travers des évidements 31 réalisés sur la périphérie dudit corps de vanne 32. Plus précisément, un boitier 39 est placé autour dudit faisceau et dudit corps de vanne 32 pour guider lesdits gaz, entre le faisceau 50 et une paroi du boitier 39, à travers les premiers évidements 31. En zone A, en amont de la vanne 30, le gaz circule à travers le faisceau 50, de l'intérieur vers l'extérieur du conduit. En zone B, en aval de la vanne 30, les gaz sont guidés radialement par le boitier 39, de l'extérieur vers l'intérieur.

Cette configuration, illustrée à la figure 3, convient plus particulièrement pour des débits de gaz d'échappement inférieur à celui évoqué en relation avec la figure 5. Ledit débit sera, par exemple, inférieur à 30g/s pour une température des gaz, par exemple, inférieure à 750°C.

La figure 4 illustre une configuration intermédiaire, avec une position de la vanne 30 qui vient modifier la circulation axiale des gaz sans pour autant les obliger à circuler entièrement à travers le faisceau 50.

Cette configuration convient plus particulièrement pour des débits de gaz est, par exemple, supérieurs à 30g/s pour une température, par exemple, inférieure à 750°C.

Il est à noter que des seconds évidements 33 permettent au fluide de refroidissement de circuler à travers le corps de vanne 32, ceci indépendamment de la position ouverte ou fermée de la vanne 30.

Ces évidements permettent aussi de mettre en contact le corps de vanne 32 qui porte le clapet 34 avec au moins le ou les tubes 54 dans lequel circule le fluide de refroidissement. Cela présente l'avantage de refroidir le clapet 34, en particulier au niveau de ses supports d'articulation 38 et ainsi, de maintenir ledit clapet 34 à une température inférieure à celle des gaz d'échappement. Autrement dit, cette condition est intéressante pour éviter une surchauffe des supports d'articulation 38 qui portent ledit clapet 34.

Il est à noter que des variantes de réalisation sont bien sûr possibles comme définie par les revendications annexées.

## Revendications

1. Générateur thermoélectrique (10) comprenant un dispositif de contrôle de débit destiné à être utilisé dans ledit générateur thermoélectrique (10), ledit générateur (10) permettant la création d'un gradient de température entre une source froide et une source chaude en au moins deux zones (A, B), **caractérisé par le fait qu'**il comprend une vanne (30), ladite vanne (30) comprenant un corps de vanne (32) et un clapet (34), ledit clapet (34) étant articulé par rapport au corps de vanne (32) et étant apte à occuper une position ouverte et une position fermée, ladite vanne (30) étant positionnée à l'intérieur dudit générateur (10), entre lesdites deux zones (A, B), de manière à moduler la quantité d'un premier fluide circulant à travers ledit générateur thermoélectrique (10), ledit générateur thermoélectrique (10) comprenant un faisceau de modules thermoélectriques, ladite vanne (30) étant configurée pour dévier radialement ledit premier fluide à travers le faisceau (50).

2. Générateur thermoélectrique (10) selon la revendication précédente, configuré pour que le premier fluide soit la source chaude dudit générateur (10).

3. Générateur thermoélectrique (10) selon l'une quelconque des revendications 1 ou 2, dans lequel ledit corps de vanne (32) comprend des premiers évidements (31) sur sa périphérie.

4. Générateur thermoélectrique (10) selon la revendication précédente, dans lequel ledit corps (32) est configuré pour que ledit premier fluide circule à travers lesdits premiers évidements (31) lorsque le clapet (34) occupe la position fermée.

5. Générateur thermoélectrique (10) selon l'une quelconque des revendications 3 ou 4, dans lequel ledit corps de vanne (32) comprend des seconds évidements (33) sur sa périphérie, lesdits seconds évidements (33) étant distincts desdits premiers évidements (31).

6. Générateur thermoélectrique (10) selon la revendication précédente, dans lequel ledit corps (32) est configuré pour qu'un second fluide constituant la source froide circule à travers lesdits seconds évidements (33), que la vanne (30) occupe sa position ouverte ou sa position fermée.

7. Générateur thermoélectrique (10) selon l'une quelconque des revendications précédentes, ledit faisceau (50) étant tubulaire de manière à définir intérieurement un conduit d'écoulement (55) dudit premier fluide à travers ledit corps de vanne (32) en position ouverte dudit clapet (34) de manière à permettre une circulation dudit fluide à travers ledit générateur (10) en évitant de passer à travers ledit faisceau (50).

8. Générateur thermoélectrique (10) selon la revendication précédente, dans lequel lesdits modules comprennent au moins un élément thermoélectrique (51) de forme annulaire, susceptible de générer un courant électrique sous l'action dudit gradient de température, prévu appliqué entre deux de ses faces, l'une, dite première face, étant définie par une surface de périphérie extérieure et l'autre, dite seconde face, étant définie par une surface de périphérie intérieure.

9. Générateur thermoélectrique (10) selon l'une quelconque des revendications précédentes, dans lequel ledit faisceau (50) présente une section sensiblement circulaire, ladite vanne (30) étant configurée pour dévier radialement ledit premier fluide à travers le faisceau (50), de l'intérieur vers l'extérieur dudit conduit (55).

10. Générateur thermoélectrique (10) selon l'une quelconque des revendications précédentes, comprenant un boitier (39) configuré pour guider ledit premier fluide à travers ledit corps de vanne (32) entre ledit faisceau (50) et une paroi dudit boitier (39).

11. Générateur thermoélectrique (10) selon la revendication précédente, dans lequel ledit boitier (39) est configuré pour guider radialement ledit premier fluide en aval de la vanne (30) de l'extérieur vers l'intérieur dudit conduit (55).

12. Générateur thermoélectrique (10) selon l'une quelconque des revendications précédentes, comprenant des premières surfaces d'échange secondaire avec le premier fluide, lesdites premières surfaces d'échange secondaire étant des ailettes qui relient les modules entre eux.

13. Générateur thermoélectrique (10) selon la revendication précédente, dans lequel les ailettes comprennent un revêtement catalytique pour assurer une conversion catalytique de composants toxiques du premier fluide.

14. Générateur thermoélectrique (10) selon l'une quelconque des revendications précédentes, configuré pour être positionné dans une ligne d'échappement de véhicule automobile de sorte que les gaz d'échappement circulant dans ladite ligne définissent ledit premier fluide et/ou dans un circuit de gaz d'échappement recirculés de véhicule automobile de sorte que lesdits gaz d'échappement recirculés circulant dans ledit circuit définissent ledit premier fluide.

## Patentansprüche

1. Thermoelektrischer Generator (10), umfassend eine Durchsatzkontrollvorrichtung, die dazu bestimmt, in dem thermoelektrischen Generator (10) verwendet zu werden, wobei der Generator (10) das Erzeugen eines Temperaturgradienten zwischen einer Kältequelle und einer Wärmequelle in mindestens zwei Zonen (A, B) erlaubt, **dadurch gekennzeichnet, dass** er eine Absperrklappe (30) umfasst, wobei die Absperrklappe (30) einen Absperrklappenkörper (32) und ein Ventil (34) umfasst, wobei das Ventil (34) bezogen auf den Absperrklappenkörper (32) schwenkbar ist und in der Lage ist, eine offene Position und eine geschlossene Position einzunehmen, wobei die Absperrklappe (30) im Inneren des Generators (10) zwischen den zwei Zonen (A, B) positioniert ist, sodass die Quantität eines ersten durch den thermoelektrischen Generator (10) hindurch zirkulierenden Fluids moduliert wird, wobei der thermoelektrische Generator (10) ein Bündel von thermoelektrischen Modulen umfasst, wobei die Absperrklappe (30) ausgestaltet ist, das erste Fluid radial durch das Bündel (50) umzuleiten.

2. Thermoelektrischer Generator (10) nach dem vorstehenden Anspruch, ausgestaltet, damit das erste Fluid die Wärmequelle des Generators (10) ist.

3. Thermoelektrischer Generator (10) nach einem der Ansprüche 1 oder 2, wobei der Absperrklappenkörper (32) erste Aussparungen (31) an seinem Umfang umfasst.

4. Thermoelektrischer Generator (10) nach dem vorstehenden Anspruch, wobei der Körper (32) ausgestaltet ist, damit das erste Fluid durch die ersten Aussparungen (31) zirkuliert, wenn die Absperrklappe (34) die geschlossene Position einnimmt.

5. Thermoelektrischer Generator (10) nach einem der Ansprüche 3 oder 4, wobei der Absperrklappenkörper (32) zweite Aussparungen (33) an seinem Umfang umfasst, wobei die zweiten Aussparungen (33) von den ersten Aussparungen (31) verschieden sind.

6. Thermoelektrischer Generator (10) nach dem vorstehenden Anspruch, wobei der Körper (32) ausgestaltet ist, damit ein zweites Fluid, das die Kältequelle bildet, durch die zweiten Aussparungen (33) hindurch zirkuliert, wenn die Absperrklappe (30) ihre offene oder ihre geschlossene Position einnimmt.

7. Thermoelektrischer Generator (10) nach einem der vorstehenden Ansprüche, wobei das Bündel (50) röhrenförmig ist, sodass im Inneren ein Strömungskanal (55) des ersten Fluids durch den Absperrklappenkörper (32) bei offener Position des Ventils (34) hindurch definiert wird, sodass eine Zirkulation des Fluids durch den Generator (10) hindurch unter Vermeidung eines Durchlaufs durch das Bündel (50) erlaubt wird.

8. Thermoelektrischer Generator (10) nach dem vorstehenden Anspruch, wobei die Module mindestens ein thermoelektrisches Element (51) ringförmiger Form umfassen, geeignet, einen elektrischen Strom unter Einwirkung des Temperaturgradienten, geplant angewendet zwischen zwei seiner Flächen, der einen, der ersten Fläche, die durch eine externe Umfangsoberfläche definiert ist, und der anderen, der zweiten Fläche, die durch eine interne Umfangsoberfläche definiert ist, zu erzeugen.

9. Thermoelektrischer Generator (10) nach einem der vorstehenden Ansprüche, wobei das Bündel (50) einen im Wesentlichen kreisförmigen Abschnitt aufweist, wobei die Absperrklappe (30) ausgestaltet ist, das erste Fluid durch das Bündel (50) hindurch radial vom Inneren zum Äußeren des Kanals (55) umzuleiten.

10. Thermoelektrischer Generator (10) nach einem der vorstehenden Ansprüche, umfassend ein Gehäuse (39), ausgestaltet zum Führen des ersten Fluids zwischen dem Bündel (50) und einer Wand des Gehäuses (39) durch den Absperrklappenkörper (32) hindurch.

11. Thermoelektrischer Generator (10) nach dem vorstehenden Anspruch, wobei das Gehäuse (39) zum Führen des ersten Fluids, der Absperrklappe (30) nachgelagert, radial vom Äußeren zum Inneren des Kanals (55) ausgestaltet ist.

12. Thermoelektrischer Generator (10) nach einem der vorstehenden Ansprüche, umfassend erste Oberflächen sekundären Austauschs mit dem ersten Fluid, wobei die ersten Oberflächen sekundären Austauschs Rippen sind, die die Module untereinander verbinden.

13. Thermoelektrischer Generator (10) nach dem vorstehenden Anspruch, wobei die Rippen eine katalytische Beschichtung umfassen, um eine katalytische Umwandlung toxischer Bestandteile des ersten Fluids zu gewährleisten.

14. Thermoelektrischer Generator (10) nach einem der vorstehenden Ansprüche, ausgestaltet, in einer Abgasleitung eines Kraftfahrzeugs derart positioniert zu sein, dass die Abgase, die in der Leitung zirkulieren, das erste Fluid definieren und/oder in einem Abgasrückführungskreislauf eines Kraftfahrzeugs derart positioniert zu sein, dass die zurückgeführten Abgase, die in dem Kreislauf zirkulieren, das erste Fluid definieren.

## Claims

1. Thermoelectric generator (10), comprising a flow control device configured to be used in said thermoelectric generator (10), said generator (10) generating a temperature gradient between a cold source and a hot source in at least two zones (A, B), **characterised in that** it comprises a valve (30), said valve (30) comprising a valve body (32) and a plate (34) hinged with respect to the valve body (32) and configured to occupy an open position and a closed position, said valve (30) being configured to be positioned inside said generator (10), between said two zones (A, B), so as to modulate the quantity of a first fluid circulating through said thermoelectric generator (10), said thermoelectric generator (10) comprising a core of thermoelectric modules, said valve (30) being configured to divert radially the first fluid through the core (50).

2. Thermoelectric generator (10) according to the previous claim, configured so that the first fluid is the hot source of said generator (10).

3. Thermoelectric generator (10) according to any of the claims 1 or 2, wherein said valve body (32) comprises first recesses (31) on its periphery.

4. Thermoelectric generator (10) according to the previous claim, wherein said body (32) is configured so that said first fluid circulates through said first recesses (31) when the plate (34) is in the closed position.

5. Thermoelectric generator (10) according to any of the claims 3 or 4, wherein said valve body (32) comprises second recesses (33) on its periphery, said second recesses (33) being separate from said first recesses (31).

6. Thermoelectric generator (10) according to the previous claim, wherein said body (32) is configured so that a second fluid constituting the cold source circulates through said second recesses (33), regardless of whether the valve (30) is in its open or closed position.

7. Thermoelectric generator (10) according to any of the previous claims, said core (50) being tubular so as to define internally a flow duct (55) of said first fluid through said valve body (32), in the open position of said plate (34), thereby allowing circulation of said fluid through said generator (10) without passing through said core (50).

8. Thermoelectric generator (10) according to the previous claim, wherein said modules comprise at least one annular thermoelectric element (51) configured to generate an electric current under the effect of said temperature gradient as applied between two of its faces, one face, called first face, being defined by an outer periphery surface, and the other face, called second face, being defined by an inner periphery surface.

9. Thermoelectric generator (10) according to any of the previous claims, wherein said core (50) features a substantially circular cross-section, said valve (30) being configured to radially divert said first fluid through the bean (50), from the inside towards the outside of said duct (55).

10. Thermoelectric generator (10) according to any of the previous claims, comprising a casing (39) configured to guide said first fluid through said valve body (32) between said core (50) and a wall of said casing (39).

11. Thermoelectric generator (10) according to the previous claim, wherein said casing (39) is configured to radially guide said first fluid downstream from the valve (30), from the outside towards the inside of said duct (55).

12. Thermoelectric generator (10) according to any of the previous claims, comprising the first secondary exchange surfaces with the first fluid, said first secondary exchange surfaces being fins that connect the modules to one another.

13. Thermoelectric generator (10) according to the previous claim, in which the fins comprise a catalytic coating for the catalytic conversion of the toxic components of the first fluid.

14. Thermoelectric generator (10) according to any of the previous claims, configured to be positioned in the exhaust line of a motor vehicle so that the exhaust fumes circulating in said line define said first fluid and/or in a circuit of re-circulated exhaust fumes of a motor vehicle so that said re-circulated exhaust fumes circulating in said circuit define said first fluid.
